# EUROPEAN PATENT APPLICATION

(11) **EP 3 239 358 A1**
(43) Date of publication of application: **01.11.2017**
(21) Application number: 15873609.0
(22) Date of filing: 22.12.2015
(51) Int. Cl.: C23C 28/00, C23C 14/14, C23C 16/06

(54) **PLATED STEEL SHEET HAVING EXCELLENT ADHESION PROPERTY AND MANUFACTURING METHOD THEREFOR**

(30) Priority: 23.12.2014 KR 20140187035
(71) Applicant: Posco, Pohang-si, Gyeongsangbuk-do 37859 (KR)
(72) Inventor: HONG, Seok-Jun, Gwangyang-si Jeollanam-do 57807 (KR); NAM, Kyung-Hoon, Gwangyang-si Jeollanam-do 57807 (KR); EOM, Mun-Jong, Gwangyang-si Jeollanam-do 57807 (KR); PARK, Sang-Hoon, Gwangyang-si Jeollanam-do 57807 (KR)
(74) Representative: Zech, Stefan Markus
(86) International application number: PCT/KR2015/014090
(87) International publication number: WO 2016/105082

(57) **Abstract**

The present invention relates to a plated steel sheet, which can be used for vehicles, home appliances, construction materials and the like, and to a method for manufacturing the plated steel sheet.

## Description

### [Technical Field]

The present disclosure relates to a plated steel sheet for vehicles, home appliances, construction materials, and the like, and to a method for manufacturing the plated steel sheet.

### [Background Art]

In general, plating is performed as a method of preventing corrosion in the manufacturing of plated steel sheets. A typical example of a plated steel sheet is a galvanized steel sheet. Galvanized steel sheets use sacrificial protection provided by zinc, and examples of galvanized steel sheets include electrogalvanized steel sheets, hot-dip galvanized steel sheets, and hot-dip galvannealed steel sheets. Although electrogalvanized steel sheets are used for the outer plates of automobiles due to the appearance thereof, the use of electrogalvanized steel sheets has been reduced because of disadvantages related to thick-plating workability, manufacturing costs, and environmental aspects. In addition, although hot-dip galvanized steel sheets are manufactured with low costs, compared to electrogalvanized steel sheets, characteristics of hot-dip galvanized steel sheets, such as mechanical characteristics, formability related to plating adhesion, and weldability relating to the lifespan of electrodes in continuous spot welding are inferior to those of electrogalvanized steel sheets because of thick plating. In addition, although hot-dip galvannealed steel sheets have high platability, such as high plating adhesion and high weldability, yielding a long electrode life because an Fe-Zn based intermetallic compound is formed as a result of the reaction between a base steel sheet and zinc (Zn), hot-dip galvannealed steel sheets have low formability because of powdering, that is, plating layer separation occurring during a machining process.

As described above, galvanized steel sheets have corrosion resistance, due to sacrificial protection. However, since the corrosion resistance of galvanized steel sheets is not always sufficient, plated steel sheets, such as multilayer plated steel sheets and zinc alloy plated steel sheets, to which alloying elements are added, to improve the corrosion resistance of galvanized steel sheets, have been proposed and developed. If the thickness of a galvanized layer is reduced, corrosion resistance is lowered, and thus, as a method of improving corrosion resistance in this type of case, a method of manufacturing a zinc-magnesium alloy plated steel sheet by adding magnesium (Mg) has recently been developed.

However, zinc-magnesium alloy plated steel sheets have poor plating layer adhesion and thus cause problems such as detachment of plating layers from products formed of zinc-magnesium alloy plated steel sheets. Thus, zinc-magnesium alloy plated steel sheets have poor workability. To address these problems, many methods, such as changing the composition of a plating layer, have been proposed. However, these problems have not yet been completely overcome.

### [Disclosure]

### [Technical Problem]

Aspects of the present disclosure may include a plated steel sheet having excellent adhesion property and workability and a method for manufacturing the plated steel sheet.

### [Technical Solution]

According to an aspect of the present disclosure, a plated steel sheet having excellent adhesion property may include a base sheet, a plating layer formed on the base sheet, and a bonding layer formed between the base sheet and the plating layer, wherein the bonding layer may have a columnar structure.

According to another aspect of the present disclosure, a method for manufacturing a plated steel sheet having excellent adhesion property may include: preparing a base sheet; forming a bonding layer having a columnar structure on the base sheet by a dry plating method; and forming a plating layer on the bonding layer.

### [Advantageous Effects]

In the plated steel sheet of the present disclosure, the adhesion between the base sheet and the plating layer proving corrosion resistance is improved. Thus, the adhesion property and workability of the plated steel sheet are improved, and the plated steel sheet may be used in various other places and environments, in addition to current application places and environments.

### [Description of Drawings]

FIG. 1 is a schematic view illustrating an example of a plated steel sheet of the present disclosure.
FIG. 2 is a schematic view illustrating a columnar structure of a bonding layer of the plated steel sheet according to the present disclosure.
FIG. 3 is a schematic view illustrating an electromagnetic levitation physical vapor deposition (EML-PVD) method according to the present disclosure.
FIG. 4 illustrates images of a plated steel sheet of Comparative Example 1, showing a cross-section design, a microstructure, and a bent surface after a powdering test, respectively.
FIG. 5 illustrates images of a plated steel sheet of Comparative Example 2, showing a cross-section design, a microstructure, and a bent surface after a powdering test, respectively.
FIG. 6 illustrates images of a plated steel sheet of Comparative Example 3, showing a cross-section design, a microstructure, and a bent surface after a powdering test, respectively.
FIG. 7 illustrates images of a plated steel sheet of Comparative Example 4, showing a cross-section design, a microstructure, and a bent surface after a powdering test, respectively.
FIG. 8 illustrates images of a plated steel sheet of Inventive Example 1, showing a cross-section design, a microstructure, and a bent surface after a powdering test, respectively.
FIG. 9 illustrates images of a plated steel sheet of Inventive Example 2, showing a cross-section design, a microstructure, and a bent surface after a powdering test, respectively.
FIG. 10 illustrates images of a plated steel sheet of Inventive Example 3, showing a cross-section design, a microstructure, and a bent surface after a powdering test, respectively.
FIG. 11 illustrates images of a plated steel sheet of Inventive Example 4, showing a cross-section design, a microstructure, and a bent surface after a powdering test, respectively.
FIG. 12 illustrates images of a plated steel sheet of Inventive Example 5, showing a cross-section design, a microstructure, and a bent surface after a powdering test, respectively.
FIG. 13 illustrates images of a plated steel sheet of Inventive Example 6, showing a cross-section design, a microstructure, and a bent surface after a powdering test, respectively.

### [Best Mode]

The inventors have invented the present invention based on the knowledge that if a layer (hereinafter, referred to as a bonding layer), having a particular structure and capable of imparting ductility, is formed between a base sheet and a plating layer, particularly a plating layer having high brittleness, adhesion between the base sheet and the plating layer, and the workability of a plated steel sheet, may be improved.

Exemplary embodiments of the present disclosure will now be described in detail with reference to the accompanying drawings. The disclosure may, however, be exemplified in many different forms and should not be construed as being limited to the specific embodiments set forth herein. Rather, these embodiments are provided so that this disclosure will be thorough and complete, and will fully convey the scope of the present invention to those skilled in the art.

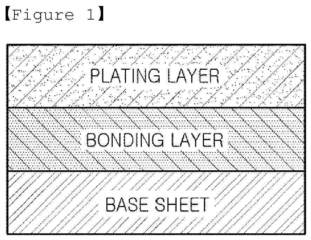

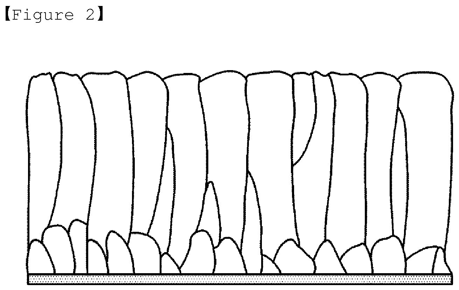

FIG. 1 is a schematic view illustrating an example of a plated steel sheet according to the present disclosure, and FIG. 2 is a schematic view illustrating a bonding layer in more detail. As illustrated in FIG. 1, the plated steel sheet of the present disclosure includes a base sheet, a plating layer formed on the base sheet, and the bonding layer formed between the base sheet and the plating layer.

As illustrated in FIG. 2, according to the present disclosure, the bonding layer of the plated steel sheet has a columnar structure. The columnar structure is a monocrystalline or polycrystalline structure formed by grains grown in a vertical direction, instead of a horizontal direction. According to the present disclosure, since the bonding layer has a columnar structure formed by vertically grown grains, the plated steel sheet may have high adhesion property.

In addition, the bonding layer having a columnar structure has many pores, that is, the bonding layer has a porous structure. This porous structure is formed by pores between vertically grown grains. According to the present disclosure, since the bonding layer has a porous structure, functioning as a buffer against strain during a machining process, for example, the plated steel sheet may have high adhesion property and workability.

The bonding layer may include an element such as zinc (Zn), aluminum (Al), silicon (Si), chromium (Cr), nickel (Ni), titanium (Ti), niobium (Nb), or molybdenum (Mo).

Preferably, the bonding layer may have a thickness of greater than 0.5 µm. As described above, when the bonding layer has a columnar structure and a thickness greater than 0.5 µm, the adhesion property of the bonding layer may be guaranteed. Since the columnar structure is formed through the growth of crystalline nuclei, if the bonding layer has a thickness less than the above-mentioned range, it may be difficult to develop the columnar structure. In addition, since it is easy to guarantee the adhesion property of the bonding layer as the thickness of the bonding layer increases, the upper limit of the thickness of the bonding layer is not limited to a particular value. The thickness of the bonding layer may be varied, according to the type or purpose of the plated steel sheet.

In the present disclosure, the plating layer is not limited to a particular type, as long as the plating layer provides corrosion resistance. For example, the plating layer may be a single metal layer, such as a Zn plating layer, an Al plating layer, a Ni plating layer, or a Mg plating layer, or may be an alloy plating layer, such as a Zn-Mg alloy plating layer, an Al-Mg alloy plating layer, a Zn-Ni alloy plating layer, a Zn-Fe alloy plating layer, or a Zn-Mg-Al alloy plating layer.

The plating layer may have a single layer structure or a multilayer structure including two more layers.

In the present disclosure, the base sheet is not limited to a particular material. For example, the base sheet may be any metal sheet on which a plating layer can be formed. The base sheet may be a general steel sheet such as a hot-rolled steel sheet, a cold-rolled steel sheet, a high-strength steel sheet, a stainless steel sheet, or a plated steel sheet, or may be a general metal sheet, such as an Al sheet.

Hereinafter, a method for manufacturing a plated steel sheet will be described according to the present disclosure.

The manufacturing method of the present disclosure includes preparing a base sheet; forming a bonding layer on the base sheet; and forming a plating layer on the bonding layer.

The bonding layer may be formed on the base sheet by a dry plating method, and typical examples of the dry plating method include a chemical vapor deposition (CVD) method and a physical vapor deposition (PVD) method. In the present disclosure, the bonding layer is formed by a dry plating method, so that the bonding layer may have porosity and a columnar structure. Since the bonding layer is formed through the growth of grain nuclei, the dry plating method may be suitable for forming the bonding layer.

An example of a CVD method includes a plasma CVD method, and examples of a PVD method include a sputtering method and an electromagnetic levitation (EML)-PVD coating method. Any CVD method or PVD method may be used without limitations, as long as the bonding layer is formed by the method.

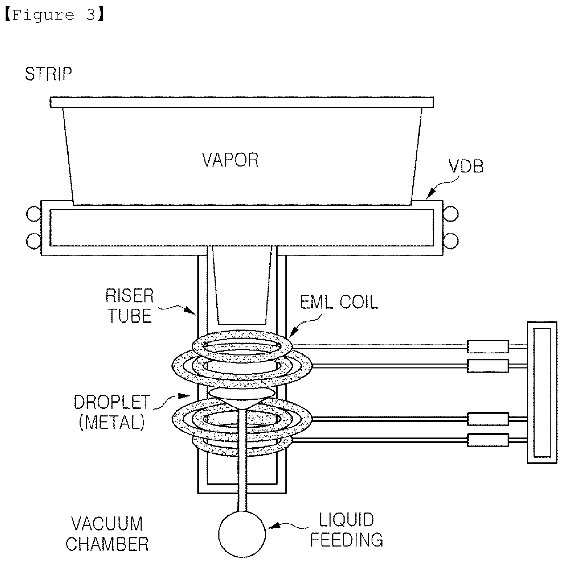

The EML-PVD coating method is a deposition technique using an EML source, and FIG. 3 schematically illustrates the EML-PVD coating method. As illustrated in FIG. 3, the EML-PVD coating method may be performed by applying high frequency power to a droplet of a coating material to vaporize the coating material by electromagnetic force, collecting the vaporized coating material in a vapor distribution box (VDB), and ejecting the vaporized coating material onto a strip through a VDB nozzle, to form a bonding layer on the strip.

After the bonding layer is formed, the plating layer may be formed. The plating layer may be formed by a wet plating method, such as an electroplating method or a hot-dipping method, or a dry plating method, such as a CVD method or a PVD method. In the present disclosure, the methods that can be used to form the plating layer are not limited. For example, any method known to those of ordinary skill in the related art may be used.

### [Mode for Invention]

Hereinafter, examples of the present disclosure will be described in detail. The following examples are for illustrative purposes only and are not for purposes of limitation.

### (Examples)

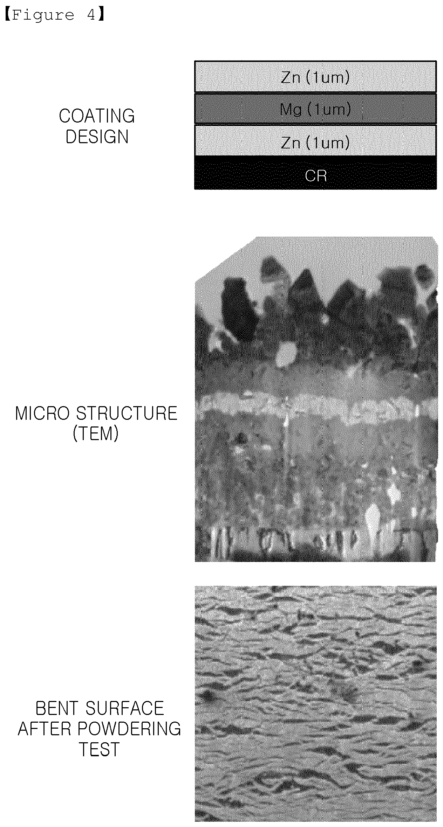

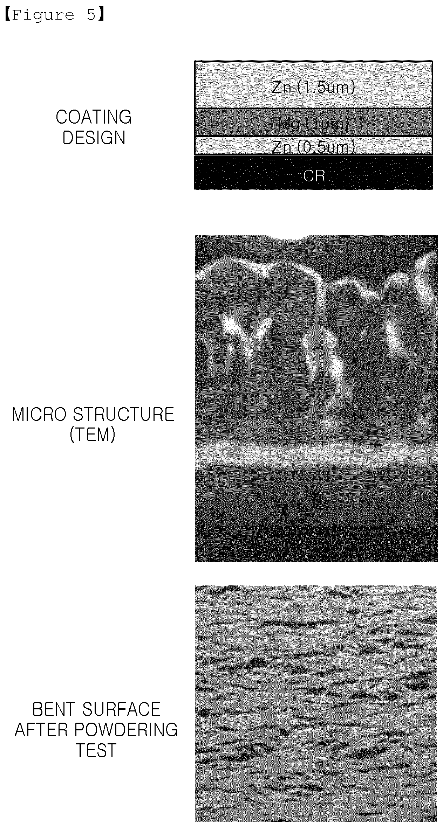

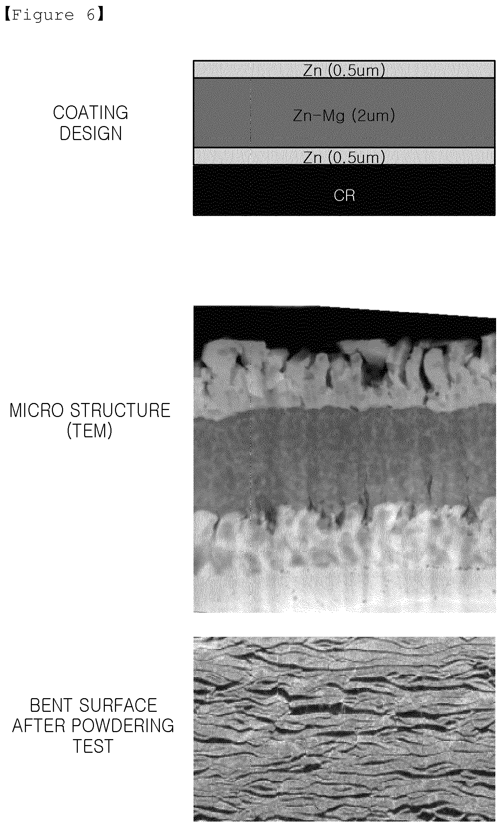

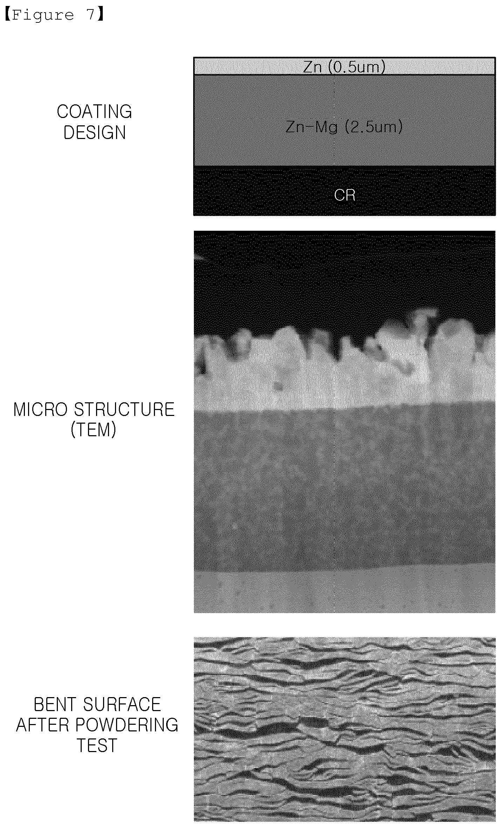

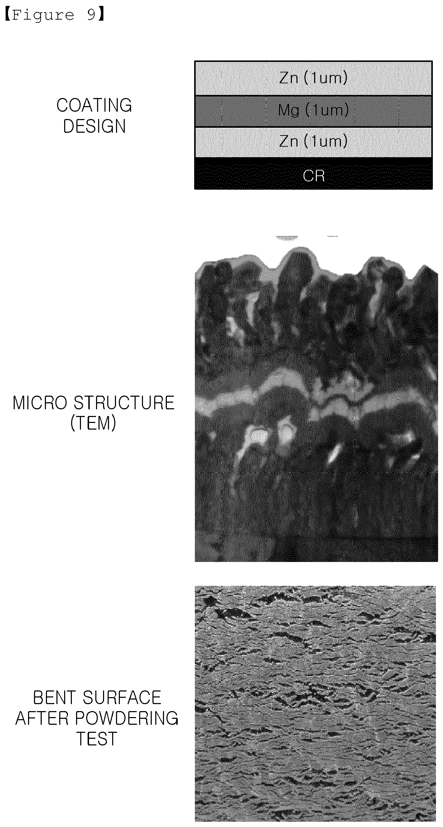

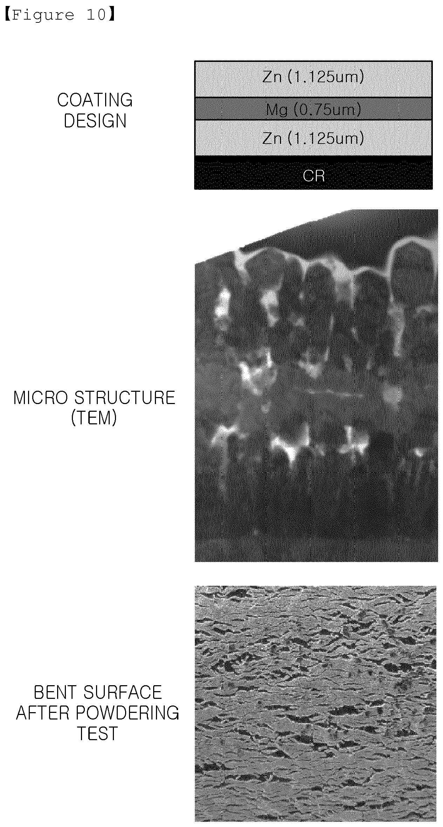

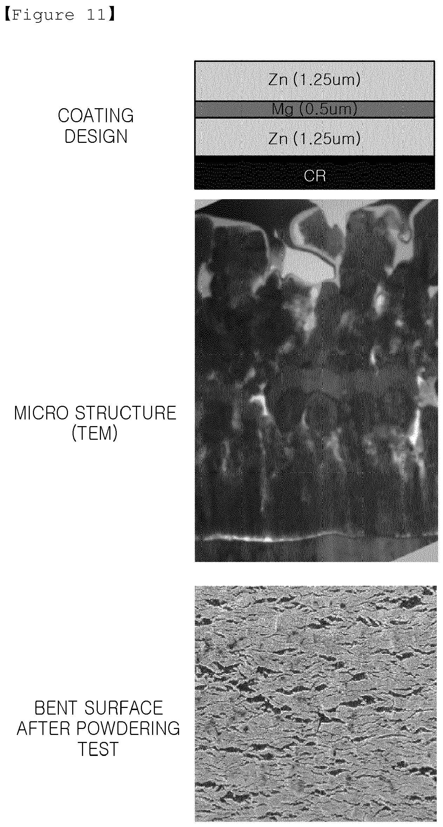

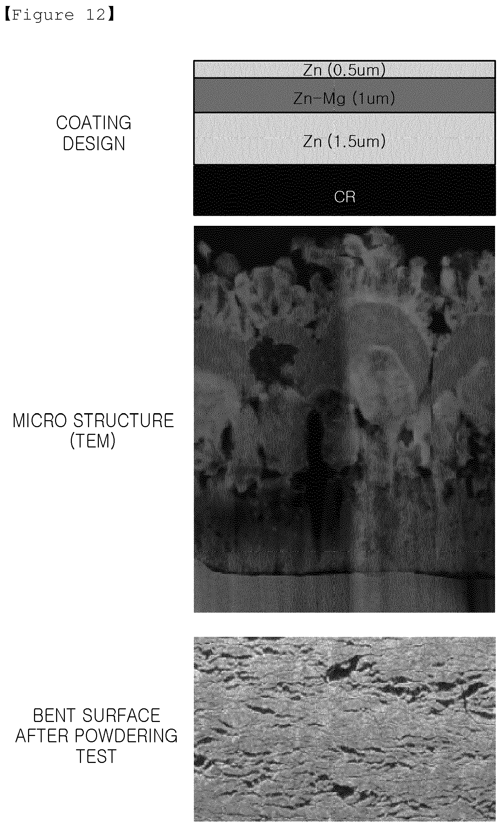

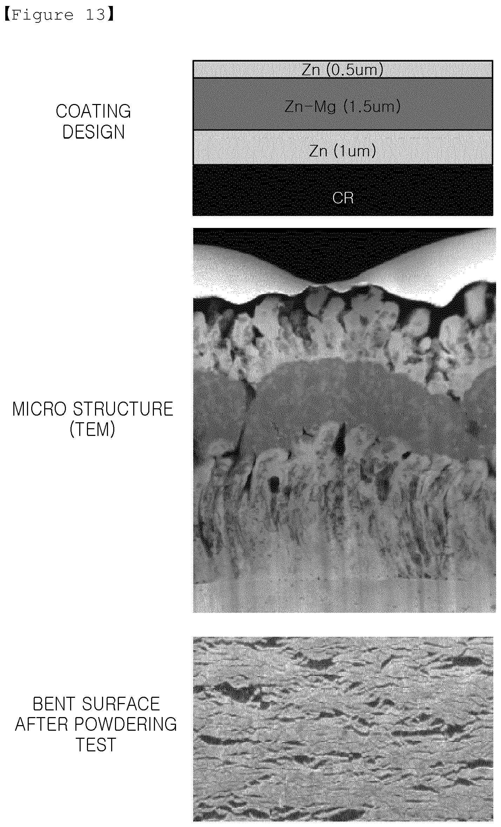

Cold-rolled steel sheets were prepared according to the present disclosure, and bonding layers and plating layers were formed on the cold-rolled steel sheets, as illustrated in Table 1 and FIGS. 4 to 13.

Cross-sections of samples were observed using a transmission electron microscope (TEM), and bent surfaces of the samples were observed after a powdering test. Results of the observations are shown in FIGS. 4 to 13.

**[Table 1]**

| Examples | Bonding Layer (Material, Thickness) | Bonding Layer Structure | Plating Layer |
|---|---|---|---|
| Comparative Example 1 | Zn, 1 µm | Columnar structure is not formed | Mg (1 µm) /Zn (1 µm) |
| Comparative Example 2 | Zn, 0.5 µm | Columnar structure is not formed | Mg (1 µm) / Zn(1.5 µm) |
| Comparative Example 3 | Zn, 0.5 µm | Columnar structure is not formed | Zn-Mg (2 µm) / Zn(0.5 µm) |
| Comparative Example 4 | - | - | Zn-Mg(2.5 µm) / Zn(0.5 µm) |
| Inventive Example 1 | Zn, 1.5 µm | Columnar structure | Mg (1 µm) / Zn(0.5 µm) |
| Inventive Example 2 | Zn, 1 µm | Columnar structure | Mg (1 µm) /Zn (1 µm) |
| Inventive Example 3 | Zn, 1.125 µm | Columnar structure | Mg (0.75 µm) / Zn (1.125 µm) |
| Inventive Example 4 | Zn, 1.25 µm | Columnar structure | Mg(0.5 µm) / Zn (1.25 µm) |
| Inventive Example 5 | Zn, 1.5 µm | Columnar structure | Zn-Mg (1 µm) / Zn(0.5 µm) |
| Inventive Example 6 | Zn, 1 µm | Columnar structure | Zn-Mg(1.5 µm) / Zn(0.5 µm) |

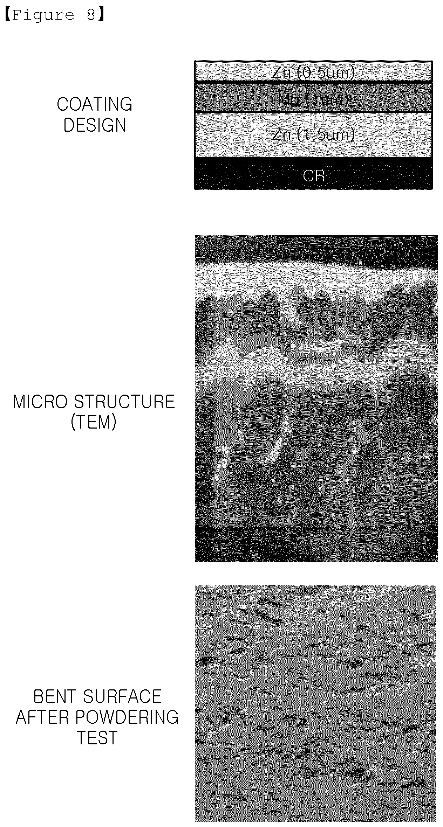

FIGS. 4 to 7 illustrate results of observation of Comparative Examples 1 to 4, and FIGS. 8 to 13 illustrate results of observation of Inventive Examples 1 to 6.

Referring to the results shown in FIGS. 4 to 7, after the powdering test, many cracks were observed in the bent surface of Comparative Example 4, in which a bonding layer was not formed, and in the bent surfaces of Comparative Examples 1 to 4, in which bonding layers not having a columnar structure were formed. In particular, it was considered that Comparative Examples 2 and 3 did not have a columnar structure because Comparative Examples 2 and 3 did not satisfy a bonding layer thickness required in the present disclosure, and thus many cracks were observed in the bent surfaces of Comparative Examples 2 and 3.

However, bonding layers having a columnar structure were formed in Inventive Examples 1 to 6, as illustrated in FIGS. 8 to 13. As a result, the number of cracks was markedly reduced in each of the bent surfaces of Inventive Examples 1 to 6 after a powdering test.

These results confirm that the plated steel sheet of the present disclosure has excellent adhesion property and workability.

## Claims

1. A plated steel sheet having excellent adhesion property, the plated steel sheet comprising a base sheet, a plating layer formed on the base sheet, and a bonding layer formed between the base sheet and the plating layer, wherein the bonding layer has a columnar structure.

2. The plated steel sheet of claim 1, wherein the bonding layer has porosity.

3. The plated steel sheet of claim 1, wherein the bonding layer has a thickness greater than 0.5 µm.

4. The plated steel sheet of claim 1, wherein the bonding layer comprises at least one selected from the group consisting of zinc (Zn), aluminum (Al), silicon (Si), chromium (Cr), nickel (Ni), titanium (Ti), niobium (Nb), and molybdenum (Mo) .

5. The plated steel sheet of claim 1, wherein the plating layer comprises at least one selected from the group consisting of a Zn plating layer, an Al plating layer, a Ni plating layer, a Mg plating layer, a Zn-Mg alloy plating layer, an Al-Mg alloy plating layer, a Zn-Ni alloy plating layer, a Zn-Fe alloy plating layer, and a Zn-Mg-Al alloy plating layer.

6. A method for manufacturing a plated steel sheet having excellent adhesion property, the method comprising:
preparing a base sheet;
forming a bonding layer having a columnar structure on the base sheet by a dry plating method; and
forming a plating layer on the bonding layer.

7. The method of claim 6, wherein the dry plating method is a chemical vapor deposition (CVD) method or a physical vapor deposition (PVD) method.
